# EUROPEAN PATENT SPECIFICATION

(11) **EP 4 216 684 B1**
(45) Date of publication and mention of the grant of the patent: **24.09.2025**
(21) Application number: 21883198.0
(22) Date of filing: 19.10.2021
(51) Int. Cl.: H05K 5/00, H04M 1/02, C09K 21/02, C09D 5/18

(54) **ELECTRONIC DEVICE COMPRISING HOUSING, AND HOUSING MANUFACTURING METHOD**
ELEKTRONISCHE VORRICHTUNG MIT GEHÄUSE UND GEHÄUSEHERSTELLUNGSVERFAHREN
DISPOSITIF ÉLECTRONIQUE COMPRENANT UN BOÎTIER, ET PROCÉDÉ DE FABRICATION DE BOÎTIER

(30) Priority: 19.10.2020 KR 20200135133
(43) Date of publication of application: 26.07.2023
(73) Proprietor: Samsung Electronics Co., Ltd., Suwon-si, Gyeonggi-do 16677 (KR)
(72) Inventor: JUNG, Hyunjung, Suwon-si, Gyeonggi-do 16677 (KR); HWANG, Hangyu, Suwon-si, Gyeonggi-do 16677 (KR); CHO, Sungho, Suwon-si, Gyeonggi-do 16677 (KR); HONG, Ingook, Suwon-si, Gyeonggi-do 16677 (KR); HWANG, Changyoun, Suwon-si, Gyeonggi-do 16677 (KR); KIM, Jongsik, Suwon-si, Gyeonggi-do 16677 (KR); HAN, Seungsoo, Suwon-si, Gyeonggi-do 16677 (KR)
(74) Representative: Gulde & Partner
(86) International application number: PCT/KR2021/014599
(87) International publication number: WO 2022/086129

(56) References cited:
- CN-A- 108 989 526
- JP-A- 2014 210 341
- JP-A- H0 584 812
- KR-A- 20100 017 657
- KR-B1- 100 750 294
- KR-B1- 100 784 442

## Description

### [Technical Field]

An embodiment of the disclosure relates to an electronic device including a housing comprising a flame retardant layer, and a method for manufacturing the housing.

### [Background Art]

An electronic device may include a housing forming an exterior. As design becomes a differentiator due to enhancement of specifications of electronic devices such as smartphones, the housing forming the exterior of the electronic device is being implemented to have a visually luxurious texture.

The following prior art publications are related to flame retardant layers in electronic devices: CN 108 989 526 A, JP 2014 210341 A, KR 2010 0017657 A and KR 100 750 294 B1.

### [Disclosure of Invention]

### [Technical Problem]

A battery may explode due to an external shock, external pressure, or abnormality of a power system. The housing may at least cushion the explosion of the battery, but combustion of the housing may lead to a fire.

Embodiments of the disclosure provide an electronic device including a housing having flame retardancy, and a method for manufacturing the housing.

### [Solution to Problem]

The invention is set out in the appended set of claims, wherein the figures and respective description relate to advantageous embodiments thereof.

### [Advantageous Effects of Invention]

According to various embodiments of the disclosure, a housing forming the exterior of an electronic device may secure flame retardancy, thereby improving stability and reliability of the electronic device.

In addition, effects that may be obtained from or predicted by various embodiments of the disclosure will be directly or implicitly disclosed in the detailed description of the embodiments of the disclosure. For example, various effects predicted according to various embodiments of the disclosure will be disclosed in the detailed description to be described later.

### [Brief Description of Drawings]

FIG. 1 is a perspective view of a front surface of a mobile electronic device according to an embodiment.
FIG. 2 is a perspective view of a rear surface of the electronic device in FIG. 1 according to an embodiment.
FIG. 3 is an exploded perspective view of the electronic device in FIG. 1 according to an embodiment.
FIG. 4 is an exploded perspective view of the electronic device in FIG. 1 according to another embodiment.
FIG. 5 illustrates a flowchart for manufacturing the rear plate in FIG. 3 or the housing structure in FIG. 4 according to an embodiment.
FIG. 6 illustrates a laminated structure of the rear plate in FIG. 3 or the housing structure in FIG. 4 according to an embodiment.
FIG. 7 illustrates a laminated structure of the rear plate in FIG. 3 or the housing structure in FIG. 4 according to an embodiment.
FIG. 8 illustrates a laminated structure of the rear plate in FIG. 3 or the housing structure in FIG. 4 according to another embodiment.
FIG. 9 illustrates a laminated structure of the rear plate in FIG. 3 or the housing structure in FIG. 4 according to various embodiments.
FIG. 10 illustrates a laminated structure of the rear plate in FIG. 3 or the housing structure in FIG. 4 according to various embodiments.
FIG. 11 illustrates a laminate structure of the rear plate in FIG. 3 or the housing structure in FIG. 4 according to various embodiments.
FIG. 12 illustrates a laminated structure of the rear plate in FIG. 3 or the housing structure in FIG. 4 according to various embodiments.
FIG. 13 illustrates a laminated structure of the rear plate in FIG. 3 or the housing structure in FIG. 4 according to various embodiments.
FIG. 14 illustrates a laminated structure of the rear plate in FIG. 3 or the housing structure in FIG. 4 according to various embodiments.
FIG. 15 illustrates an assembly including a first support member, a battery, and a metal support member according to an embodiment.
FIG. 16 illustrates a laminated structure of a cover member, a metal support member, and a battery according to an embodiment.

### [Mode for the Invention]

Hereinafter, various embodiments of the disclosure will be described with reference to the accompanying drawings.

The electronic device according to various embodiments disclosed herein may be one of various types of electronic devices. The electronic devices may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that various embodiments of the disclosure and the terms used therein are not intended to limit the technological features set forth herein to particular embodiments and include various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "a first", "a second", "the first", and "the second" may be used to simply distinguish a corresponding element from another, and does not limit the elements in other aspect (e.g., importance or order).

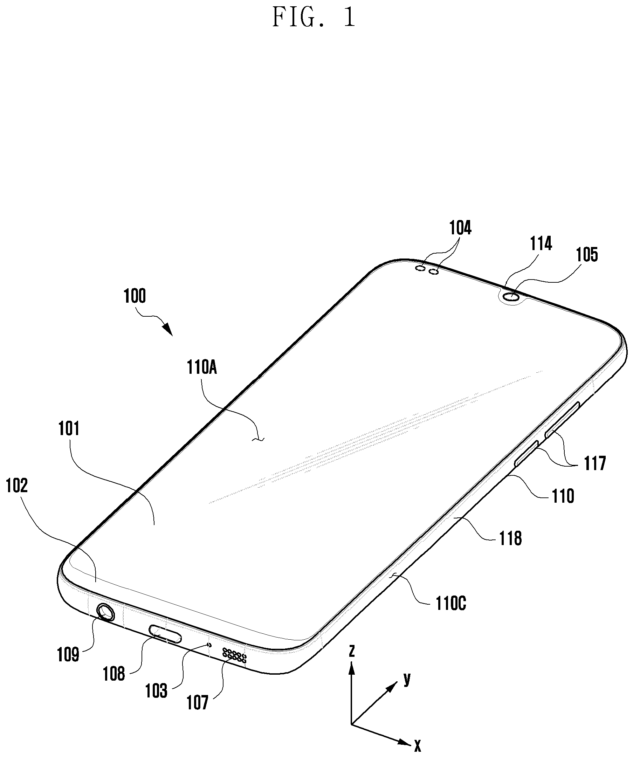

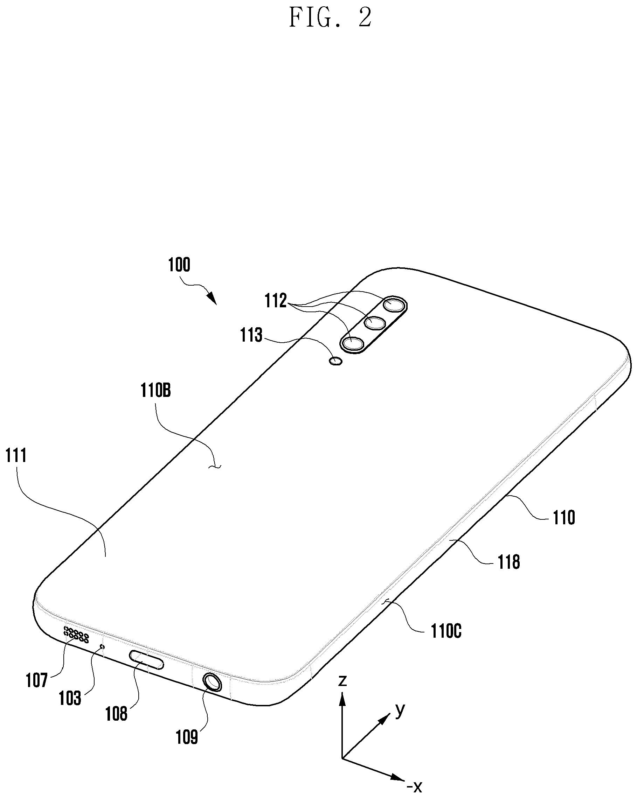

FIG. 1 is a perspective view of a front surface of a mobile electronic device 100 according to an embodiment. FIG. 2 is a perspective view of a rear surface of the electronic device 100 in FIG. 1 according to an embodiment.

Referring to FIGS. 1 and 2, an electronic device 100 according to an embodiment may include a housing 110 including a first surface (or front surface) 110A, a second surface (or rear surface) 110B, and a side surface 110C surrounding a space between the first surface 110A and the second surface 110B. In various embodiments, the housing 110 may include a structure forming a portion of the first surface 110A, the second surface 110B, and the side surface 110C. According to an embodiment, the first surface 110A may be formed by a front plate (or a first plate) 102 (e.g., a glass plate or polymer plate including various coating layers) that is substantially transparent at least in part. The second surface 110B may be formed by a rear plate (or a second plate) 111 that is substantially opaque. The rear plate 111 may be formed of, for example, coated or tinted glass, ceramic, polymer, metal (e.g., aluminum, stainless steel (STS), or magnesium), or a combination of at least two of the above materials. The side surface 110C may be formed by a side bezel structure (or "side member") 118 coupled to the front plate 102 and the rear plate 111 and including metal and/or polymer. In some embodiments, the rear plate 111 and the side bezel structure 118 may be integrally formed and include the same material (e.g., a metal material such as aluminum or a non-metal material such as polymer).

According to an embodiment, the electronic device 100 may include at least one or more of a display 101, audio modules 103, 107, and 114, a sensor module 104, camera modules 105, 112, and 113, key input devices 117, and a connector holes 108 and 109. In some embodiments, the electronic device 100 may exclude at least one (e.g., the key input devices 117) of the elements or further include other elements (e.g., a fingerprint sensor or a light-emitting device).

The display 101 may be exposed, for example, through a substantial portion of the front plate 102. In some embodiments, corners of the display 101 may be formed to have substantially the same shape as an adjacent outer shape of the front plate 102. In another embodiment (not shown), in order to increase the exposed area of the display 101, the distance between the outer edge of the display 101 and the outer edge of the front plate 102 may be formed to be substantially the same.

In another embodiment (not shown), a recess or opening may be formed in a portion of a screen display area of the display 101, and at least one or more of the audio module 114, the sensor module 104, and the camera module 105, which are aligned with the recess or opening, may be included. In another embodiment (not shown), at least one or more of the audio module 114, the sensor module 104, and the camera module 105 may be included in the rear surface of the screen display area of the display 101. In another embodiment (not shown), the display 101 may be connected to a touch detection circuit, a pressure sensor capable of measuring the intensity (pressure) of a touch, and/or a digitizer for detecting a magnetic field type stylus pen or disposed adjacent thereto.

The audio modules 103, 107, and 114 may include, for example, a microphone hole (e.g., the audio module 103) and speaker holes (e.g., the audio modules 107 and 114). A microphone for obtaining external sound may be disposed inside the microphone hole, and in some embodiments, a plurality of microphones may be disposed to detect the direction of sound. The speaker holes may include an external speaker hole (e.g., the audio module 107) and a receiver hole (e.g., the audio module 114) for a call. In some embodiments, the speaker holes and the microphone hole may be implemented as a single hole, or a speaker may be included without the speaker holes (e.g., a piezo speaker).

The sensor module 104 may generate an electrical signal or data value corresponding to an internal operation state of the electronic device 100 or an external environmental state. The sensor module 104 (e.g., a proximity sensor or an illuminance sensor) may be positioned to correspond to, for example, the first surface 110A inside the housing 110. The position of the sensor module 104 may vary without being limited to the embodiment in FIG. 1, and for example, the sensor module 104 may include a fingerprint sensor. The electronic device 100 may include various sensor modules (e.g., an HRM sensor) disposed on the second surface 110B. The electronic device 100 may further include a sensor module that is not shown, for example, at least one of a gesture sensor, a gyro sensor, an atmosphere pressure sensor, a magnetic sensor, an acceleration sensor, a grip sensor, a color sensor, an infrared (IR) sensor, a biometric sensor, a temperature sensor, or a humidity sensor.

The camera modules 105, 112, and 113 may include, for example, a first camera device (e.g., the camera module 105) positioned to correspond to the first surface 110A inside the housing 110, a second camera device (e.g., the camera module 112) positioned to correspond to the second surface 110B, and/or a flash (e.g., the camera module 113). The first camera device and/or the second camera device may include one or more lenses, an image sensor, and/or an image signal processor. The flash may include, for example, a light-emitting diode or a xenon lamp. In some embodiments, two or more lenses (an infrared camera and wide-angle and telephoto lenses) and image sensors may be positioned corresponding to one surface of the electronic device 100.

The key input devices 117 may be positioned, for example, on the side surface 110C of the housing 110. In another embodiment, the electronic device 100 may exclude some or all of the key input devices 117, and the excluded key input devices 117 may be implemented in another form such as soft keys on the display 101. In some embodiments, the key input device may include a sensor module (not shown) positioned corresponding to the second surface 110B of the housing 110.

The light-emitting device (not shown) may be positioned to correspond to, for example, the first surface 110A inside the housing 110. The light-emitting device may provide, for example, state information of the electronic device 100 in the form of light. In another embodiment, the light-emitting device may provide, for example, a light source interworking with the operation of the camera module 105. The light-emitting device may include, for example, an LED, an IR LED or a xenon lamp.

The connector holes 108 and 109 may include a first connector hole 108 for accommodating a connector (e.g., a USB connector) for transmitting and receiving power and/or data to and from an external electronic device and/or a second connector hole (e.g., an earphone jack) 109 for accommodating a connector for transmitting and receiving an audio signal to and from an external electronic device.

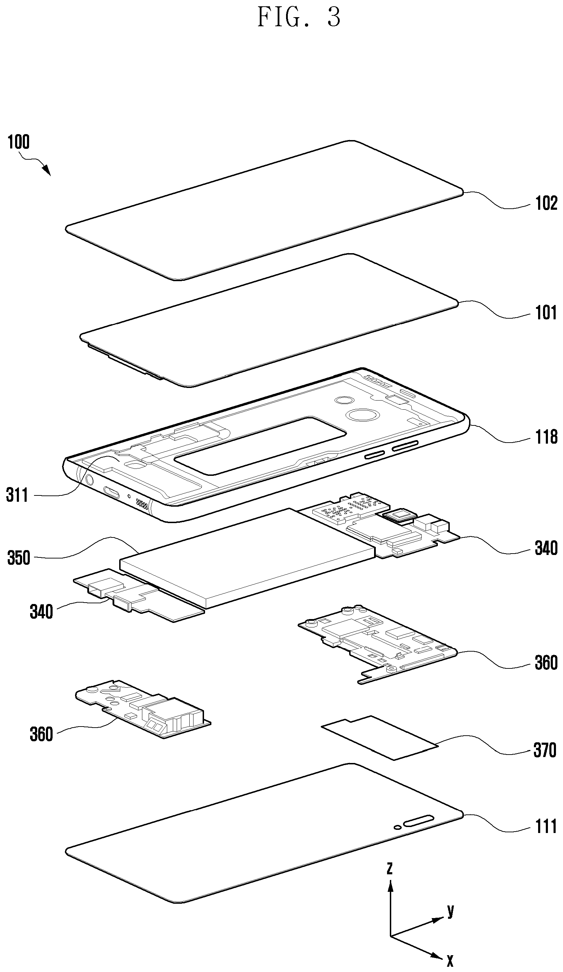

FIG. 3 is an exploded perspective view of the electronic device 100 in FIG. 1 according to an embodiment.

Referring to FIG. 3, the electronic device 100 according to an embodiment may include a front plate 102, a rear plate 111, a side bezel structure 118, a first support member 311 (e.g., a bracket), a display 101, a printed circuit board 340, a battery 350, a second support member 360 (e.g., a rear case), or an antenna 370. In some embodiments, the electronic device 100 may exclude at least one (e.g., the first support member 311 or the second support member 360) of the elements or may further include other elements.

The first support member 311 may be disposed, for example, inside the electronic device 100 to be connected to the side bezel structure 118 or integrally formed with the side bezel structure 118. The first support member 311 may be formed of, for example, a metal material and/or a non-metal (e.g., polymer) material. The first support member 311 may have the display 101 coupled to one side thereof and the printed circuit board 340 coupled to the opposite side thereof. A processor, a memory, and/or an interface may be mounted on the printed circuit board 340. The processor may include, for example, one or more of a central processing unit, an application processor, a graphic processing unit, an image signal processor, a sensor hub processor, or a communication processor. The memory may include, for example, volatile memory or non-volatile memory. The interface may include, for example, a high-definition multimedia interface (HDMI), a universal serial bus (USB) interface, an SD card interface, and/or an audio interface. For example, the interface may electrically or physically connect the electronic device 100 to an external electronic device and include a USB connector, an SD card/ MMC connector, or an audio connector.

The battery 350 is a device for supplying power to at least one element of the electronic device 100 and may include, for example, a non-rechargeable primary battery, a rechargeable secondary battery, or a fuel cell. At least a part of the battery 350 may be disposed on substantially the same plane as, for example, the printed circuit board 340. The battery 350 may be integrally disposed inside the electronic device 100 or disposed detachably from the electronic device 100.

The antenna 370 may be disposed between the rear plate 111 and the battery 350. The antenna 370 may include, for example, a near-field communication (NFC) antenna, a wireless charging antenna, and/or a magnetic secure transmission (MST) antenna. For example, the antenna 370 may perform short-range communication with an external device or wirelessly transmit and receive power required for charging. In another embodiment, a part of the side bezel structure 118 and/or the first support member 311 or a combination thereof may configure an antenna structure.

According to an embodiment, when viewed from above of the front plate 102 (e.g., when viewed in the -z-axis direction), at least one electronic component (e.g., the sensor module 104 or the camera module 105 in FIG. 1) may be positioned to at least partially overlap the display 101. In this case, at least one electronic component may be positioned between the display 101 and the first support member 311. According to some embodiments, at least one electronic component may be positioned between the first support member 311 and the printed circuit board 340, and in this case, the first support member 311 may include an opening corresponding thereto.

In an embodiment, at least one electronic component (e.g., the sensor module 104 or the camera module 105 in FIG. 1) may be disposed under at least a portion of a screen (e.g., a screen display area or an active area) of the display 101. For example, at least one electronic component may be positioned on the rear surface of the screen, or below or beneath the screen. According to an embodiment, at least one electronic component may be positioned inside the electronic device 100 while being aligned with a recess formed on the rear surface of the display 101. The position of at least one electronic component may not be visually distinguished (or exposed), and at least one electronic component may perform a related function. For example, when viewed from above of the screen (e.g., when viewed in the -z-axis direction), the camera module 105 may be disposed to overlap at least a portion of the screen, thereby obtaining an image of an external subject without being exposed to the outside. For example, when viewed from above of the screen, the sensor module 104 may be disposed to overlap at least a portion of the screen, thereby performing a corresponding sensing function without being exposed to the outside. A partial area of the display 101 at least partially overlapping at least one electronic component may include a different pixel structure and/or wiring structure from those of other areas. For example, a partial area of the display 101 at least partially overlapping at least one electronic component may have a different pixel density from those of other areas. A pixel structure and/or wiring structure formed in a partial area of the display 101 at least partially overlapping at least one electronic component may reduce loss when various types of signals (e.g., light or ultrasonic waves) related to at least one electronic component pass between the outside and at least one electronic component. According to some embodiments, a plurality of pixels may not be disposed in a partial area of the display 101 that at least partially overlaps at least one electronic component. According to another embodiment, at least one electronic component (e.g., the camera module 105) may be positioned inside the electronic device 100 while being aligned with an opening (e.g., a through-hole or a notch) formed in the display 101.

According to one embodiment, the second support member 360 may be positioned between the first support member 311 and the rear plate 111 and coupled to the first support member 311 through a fastening element such as a bolt. At least a portion of the printed circuit board 340 may be disposed between the first support member 311 and the second support member 360, and the second support member 360 may cover and protect the printed circuit board 340.

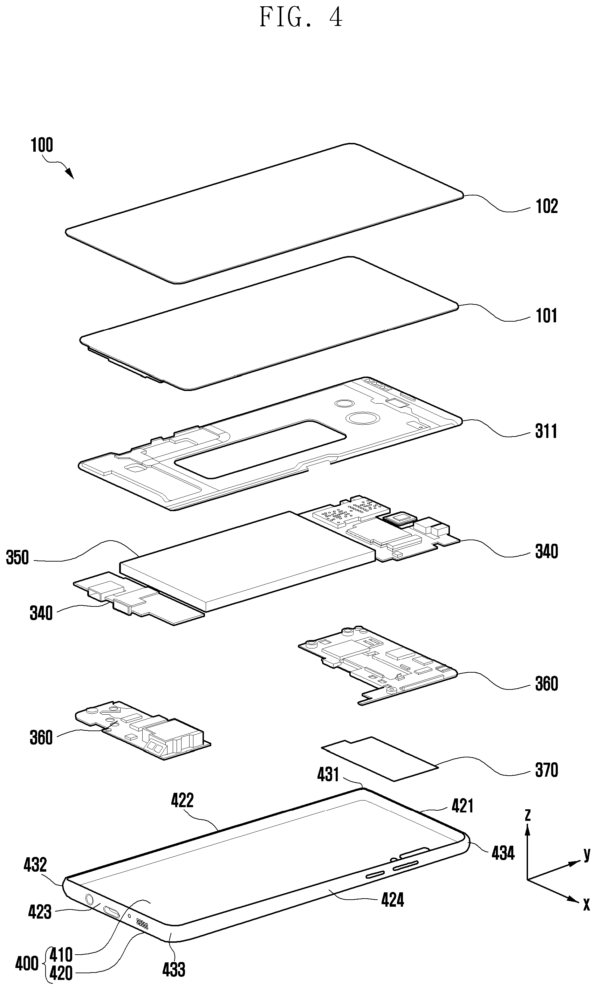

FIG. 4 is an exploded perspective view of the electronic device 100 in FIG. 1 according to another embodiment.

Referring to FIG. 4, for example, the electronic device 100 may include a front plate 102, a housing structure 400, a first support member 311, a display 101, a printed circuit board 340, a battery 350, a second support member 360, or an antenna 370. According to an embodiment, the housing structure 400 may be implemented by integrally forming the side bezel structure 118 and the rear plate 111 in FIG. 3. In various embodiments, the front plate 102 may be referred to as a first plate and the housing structure 400 may be referred to as a second plate.

According to an embodiment, the housing structure 400 may include a flat portion 410 and a curved portion 420. The flat portion 410 may form at least a portion of the rear surface (e.g., the rear surface 110B in FIG. 2) of the electronic device 100. The curved portion 420 may form at least a portion of the side surface (e.g., the side surface 110C in FIG. 2) of the electronic device 100. The curved portion 420 may include a first curved portion 421, a second curved portion 422, a third curved portion 423, and/or a fourth curved portion 424. The curved portion 420 may be curved from the flat portion 410 toward the front plate 102 to extend seamlessly. The first curved portion 421 and the third curved portion 423 may extend in parallel to be spaced apart from each other. The second curved portion 422 may connect one end of the first curved portion 421 and one end of the third curved portion 423. The fourth curved portion 424 may connect the other end of the first curved portion 421 and the other end of the third curved portion 433, and extend in parallel to be spaced apart from the second curved portion 422. The curved portion 420 may include a first corner 431 that seamlessly connects the first curved portion 421 and the second curved portion 422. The curved portion 420 may include second corner 432 that seamlessly connects the second curved portion 422 and the third curved portion 423. The curved portion 420 may include a third corner 433 that seamlessly connects the third curved portion 423 and the fourth curved portion 424. The curved portion 420 may include a fourth corner 434 that seamlessly connects the first curved portion 421 and the fourth curved portion 424. The first support member 311 may be connected to the curved portion 420 of the housing structure 400.

According to various embodiments, the electronic device 100 may further include various elements according to provision forms thereof. These elements may have various changes according to the convergence trend of the electronic device 100, so it is impossible to enumerate all, but elements equivalent to the above-mentioned elements may be further included in the electronic device 100. According to various embodiments, specific elements may be excluded from the above elements or replaced by other elements according to provision forms thereof.

According to an embodiment, the rear plate (or back cover) 111 in FIG. 3 and the housing structure 400 in FIG. 4 may include a flame retardant material. For example, if the battery 350 explodes due to the external impact, the external pressure, or the malfunction in the power system, flame with heat may be emitted toward the rear plate 111 or the housing structure 400. The flame retardant material may make it difficult for the rear plate 111 and the housing structure 400 to combust due to the flame with heat when the battery 350 explodes or delay the combustion thereof. The flame retardant material may act as a buffer for mitigating the effect of explosion of the battery 350.

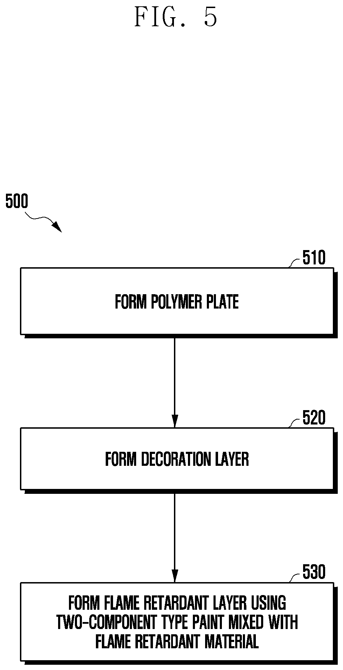

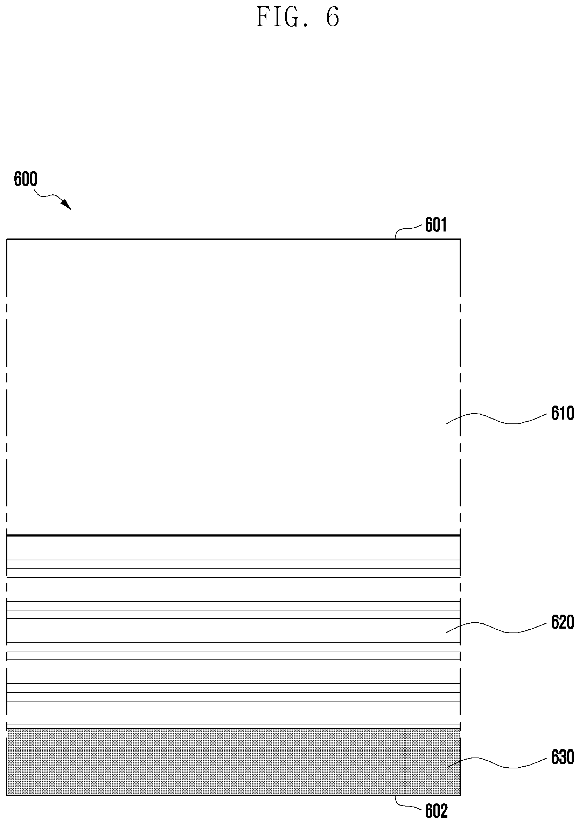

FIG. 5 illustrates a flowchart 500 for manufacturing the rear plate 111 in FIG. 3 or the housing structure 400 in FIG. 4 according to an embodiment. FIG. 6 illustrates a laminated structure 600 of the rear plate 111 in FIG. 3 or the housing structure 400 in FIG. 4 according to an embodiment.

Referring to FIG. 5, a polymer plate may be formed in operation 510. In operation 520, a decoration layer may be formed. In operation 530, a flame retardant layer may be formed using a two-component type paint mixed with a flame retardant material. Referring to FIG. 6, in an embodiment, the decoration layer 620 may be positioned between the polymer plate 610 and the flame retardant layer 630. The laminated structure 600 may include a first surface 601 formed by the polymer plate 610 and a second surface 602 formed by the flame retardant layer 630 and facing in the opposite direction of the first surface 601. If the rear plate 111 in FIG. 3 or the housing structure 400 in FIG. 4 including the laminated structure 600 is disposed in the electronic device 100 in FIG. 1, the first surface 601 may form the outer surface of the electronic device 100, and the second surface 602 may form the inner surface of the electronic device 100.

According to an embodiment, the polymer plate 610 may form a frame of the rear plate 111 in FIG. 3 or the housing structure 400 in FIG. 4 and may be a basis for disposing a plurality of layers. The polymer plate 610 may be substantially transparent. The polymer plate 610, for example, may be colorless or may have a transparent color, enabling all or most colors to transmit (or pass) therethrough. If light incident on the first surface 601 passes through the polymer plate 610 and reaches the decoration layer 620, various visual effects of the decoration layer 620 may be provided to a user (e.g., visual recognition). The flame retardant layer 630 may ensure flame retardancy for the rear plate 111 in FIG. 3 or the housing structure 400 in FIG. 4 including the laminated structure 600. For example, the battery may explode due to the external impact, the external pressure, or the malfunction of the power system. When the battery explodes, flame with heat may be emitted toward the rear plate 111 in FIG. 3 or the housing structure 400 in FIG. 4. The flame retardant layer 630 may make it difficult for the rear plate 111 in FIG. 3 or the housing structure 400 in FIG. 4 to combust due to the flame with heat when the battery explodes or delay the combustion thereof. The flame retardant material may act as a buffer for mitigating the effect of explosion of the battery.

According to an embodiment, the polymer plate 610 may be formed by injection molding. The polymer plate 610 may include, for example, engineering plastic (e.g., polycarbonate (PC) or polymethyl methacrylate (PMMA)). As another example, the polymer plate 610 may include a material (e.g., fiber reinforced plastic (FRP)) in which the engineering plastic is mixed with various reinforcing materials such as glass fiber or carbon fiber. The polymer plate 610 may have strength capable of reducing damage caused by the external impact or the external pressure. The polymer plate 610 may have rigidity capable of reducing deformation (e.g., twisting or bending) due to the external impact or the external pressure. In various embodiments, the polymer plate 610 may have impact resistance, abrasion resistance, heat resistance, cold resistance, chemical resistance, or electrical insulation.

If light is incident on the first surface 601, various visual effects of the polymer plate 610 and the decoration layer 620 may be provided to the user. The visual effect may include, for example, various visual properties such as visual texture (or visual surface texture), visual patterns, or visual colors that the user feels about the laminated structure 600 when looking at the first surface 601. If light is incident on the first surface 601, various visual effects may be provided to the user due to the medium properties of a plurality of layers included in the laminated structure 600. The visual effect may be variously implemented based on, for example, various phenomena of light such as reflection, refraction, scattering, or dispersion of the light incident on the first surface 601 by the laminated structure 600. The visual effect may be variously implemented based on, for example, the light transmittance and refractive index of each layer and the reflectance in the interface between the layers. The decoration layer 620 may include one or more layers for various visual effects.

According to various embodiments (not shown), the laminated structure 600 may include a primer positioned between the polymer plate 610 and the decoration layer 620. After disposing the primer on the polymer plate 610, the decoration layer 620 may be combined with the primer. For example, the primer may be disposed on the polymer plate 610 through various methods such as vacuum deposition or spattering. The polymer plate 610 and the decoration layer 620 may be combined without gaps or air bubbles by the primer. According to various embodiments, the primer may be colored, and when light is incident on the first surface 601, a visually unique color of the laminated structure 600 may be implemented by the primer.

According to an embodiment, the flame retardant layer 630 may be formed using a two-component type paint mixed with a flame retardant material. The two-component type paint may indicate a paint that is cured by mixing a curing agent. According to an embodiment, the flame retardant material may include an inorganic material such as magnesium hydroxide, aluminum hydroxide, tin zinc, phosphorus-based materials, guanidine-based materials, molybdate, or zirconium. The aluminum hydroxide may produce water molecules by, for example, endothermic reaction and delay or prevent combustion by the cooling effect according thereto. A phosphorus-based flame retardant material (e.g., bisphenol-A bis (disphenyl phosphate)), for example, may form a carbon film with the polymetaphosphoric acid by thermal decomposition of a phosphorus component, and the carbon film may prevent combustion by blocking contact for oxidation. An inorganic flame retardant material may be brittle (e.g., a property of breaking due to absence of ductility) or hard. The two-component type paint may include a main material (or a crude solution) and a curing agent. The flame retardant layer 630 is formed by an operation of forming a first mixture material by mixing the flame retardant material in a powder form with a main material (e.g., dispersion mixing) in a liquid form, an operation of forming a second mixture material by mixing the first mixture material with a curing agent, and an operation of disposing the second mixture material to the decoration layer 620. The main material included in the two-component type paint may contribute to the softness of the flame retardant layer 630. According to an embodiment, the main material included in the two-component type paint may include a polymer that is softer than the flame retardant material, and may include, for example, polyester, acrylic, and/or epoxy. The curing agent of the two-component type paint may include, for example, urethane and/or melamine and affect curing conditions (e.g., curing time). The main material included in the two-component type paint may contribute to the combining strength (or adhesive strength) between the flame retardant layer 630 and the decoration layer 620 in consideration of the brittleness or hardness of the flame retardant material. The main material included in the two-component type paint may contribute to the bending property and/or durability of the flame retardant layer 630 in consideration of the brittleness or hardness of the flame retardant material. The main material included in the two-component type paint may contribute to preventing the flame retardant layer 630 from being separated (or peeled off) from the decoration layer 620 or damaged, when the external impacted or external pressure is applied to the laminated structure 600. For example, if the flame retardant layer is formed of a single-liquid paint containing the flame retardant material (e.g., a paint that dries over time without the curing agent), the flame retardant layer may be separated (or peeled off) from the decoration layer 620 or damaged due to the brittleness or hardness of the flame retardant material, when the external impact or external pressure is applied to the laminated structure 600.

The flame retardant material may be mixed at a weight ratio to ensure a desired flame retardant grade. The flame retardant material may be mixed at a weight ratio capable of reducing defects of the flame retardant layer 630 while facilitating the process of disposing the flame retardant layer 630 on the decoration layer 620. According to an embodiment, the flame retardant material may have a weight ratio of about 10% to about 30% with respect to the two-component type paint.

The main material and the curing agent included in the two-component type paint may be mixed at a weight ratio capable of ensuring the properties (e.g., softness) of the flame retardant layer 630 while facilitating the process of disposing the flame retardant layer 630. For example, the main material and the curing agent may be mixed at a weight ratio of about 1:1.3. The main material and the curing agent, not limited thereto, may be mixed at various other weight ratios depending on the main material or the curing agent.

According to an embodiment, the flame retardant layer 630 may be disposed on the decoration layer 620 by spraying.

According to another embodiment, the flame retardant layer 630 may be disposed on the decoration layer 620 by printing. The flame retardant layer 630 may be disposed on the decoration layer 620 by, for example, silk-screen printing. When printing is applied to the rear plate 111 in FIG. 3 rather than the housing structure 400 in FIG. 4, the formation of the flame retardant layer 630 may be easier or the defects thereof may be reduced. Since the housing structure 400 in FIG. 4 includes the curved portion 420 extending from the flat portion 410, it may be difficult to dispose the flame retardant layer 630 on the decoration layer 620 by printing. Accordingly, in the housing structure 400 in FIG. 4, the flame retardant layer 630 may be formed by spraying rather than printing. The flame retardant layer 630, not limited to the spraying or printing, may be disposed on the decoration layer 620 through various other methods.

According to various embodiments, at least one layer included in the decoration layer 620 may include various materials for shielding the electromagnetic wave (e.g., EMI shielding).

According to various embodiments (not shown), the laminated structure 600 may further include various other layers or exclude some layers. According to various embodiments (not shown), the laminated structure 600 may further include at least one layer disposed on the first surface 601. The laminated structure 600 may include, for example, a transparent coating layer (not shown) positioned on the first surface 601, and the transparent coating layer may be a final layer for neatly protecting the polymer plate 610 from the outside. The transparent coating layer may include a clear layer and include, for example, a UV clear layer formed of a UV curing material.

According to various embodiments, the flame retardant layer 630, not limited to the embodiment in FIG. 6, may be positioned between any two layers among a plurality of layers included in the laminated structure 600.

According to various embodiments, the flame retardant layer 630 may be positioned on a first surface 601 of the polymer plate 601. In this case, the flame retardant layer 630 may be formed to be transparent or opaque, and a layer for protecting the flame retardant layer 630 from the outside may be added thereto.

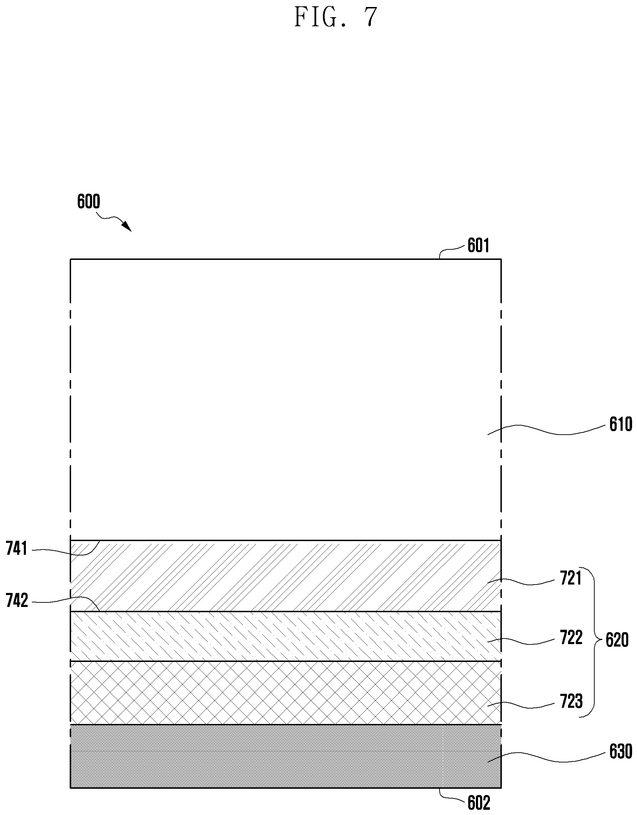

FIG. 7 illustrates a laminated structure 600 of the rear plate 111 in FIG. 3 or the housing structure 400 in FIG. 4 according to an embodiment.

Referring to FIG. 7, in an embodiment, the laminated structure 600 may include a polymer plate 610, a decoration layer 620, and a flame retardant layer 630.

According to an embodiment, the decoration layer 620 may include a UV molding layer 721, a first color layer 722, and/or a second color layer 723. The UV molding layer 721 may be positioned between the polymer plate 610 and the first color layer 722. The second color layer 723 may be positioned between the first color layer 722 and the flame retardant layer 630.

The UV molding layer 721 may be formed by, for example, rolling of uniformly spread a UV curing resin (e.g., a UV molding liquid) on the polymer plate 610 and curing the UV curing resin using ultraviolet rays onto the UV curing resin. The visual effect of the laminated structure 600 may be variously implemented based on the thickness of each layer. For example, due to the thickness of the UV molding layer 721, the visual effect by the decoration layer 620 may be delivered to the user with the sense of depth. The thickness of the polymer plate 610 may also contribute to delivering the deep visual effect by the decoration layer 620 to the user. The sense of depth may indicate perception of distance (e.g., distance perception or depth perception) in which the visual effect such as the visual texture or the visual pattern is visually delivered to the user.

According to various embodiments, the polymer plate 610 may include a first pattern formed on a surface 741 combined with the UV molding layer 721. The first pattern may be formed by transferring a pattern included on the molding surface of the mold. The first pattern may include, for example, an uneven surface including a plurality of dimples or a plurality of slits. The first pattern may provide a first visual texture to the user. For example, if light passes through the first surface 601 and reaches the interface between the polymer plate 610 and the UV molding layer 721, the first pattern (e.g., a diffraction grating) may provide the first visual texture to the user by separating the spectrum of light according to the wavelength and causing the user to view the monochromatic lights of the visible light. The first visual texture may be provided to the user with the sense of depth due to the thickness of the polymer plate 610.

According to various embodiments, the UV molding layer 721 may include a second pattern formed on a surface 742 combined with the first color layer 722. The second pattern may include, for example, an uneven surface including a plurality of dimples or a plurality of slits. According to various embodiments, the second pattern may be different from the first pattern formed on the surface 741 of the polymer plate 610 combined with the UV molding layer 721. The second pattern may provide a second visual texture to the user. For example, if light passes through the first surface 601 and reaches the interface between the UV molding layer 721 and the second color layer 723, the second pattern (e.g., a diffraction grating) may provide a second visual texture to the user by separating the spectrum of light according to the wavelength and causing the user to view the monochromatic lights of the visible light. The second visual texture may be provided to the user with the sense of depth due to the thickness of the polymer plate 610 and the thickness of the UV molding layer 721. If the polymer plate 610 includes the first pattern formed on the surface 741 combined with the UV molding layer 721, the visual texture by the first pattern and the visual texture by the second pattern of the UV molding layer 721 may be provided to the user with different sense of depths.

According to various embodiments, the laminated structure 600 may include a primer positioned between the polymer plate 610 and the UV molding layer 721. After disposing the primer on the polymer plate 610, the UV molding layer 721 may be combined with the primer. The polymer plate 610 and the UV molding layer 721 may be combined without gaps or air bubbles by the primer. In the case where the polymer plate 610 includes the first pattern formed on the surface 741 combined with the UV molding layer 721, the primer may be formed in a thin film of about 1µm or less having a form conforming to the first pattern. The primer may include a material having the combination affinity with the polymer plate 610 and the UV molding layer 721. According to various embodiments, the primer may have a color, and when light is incident on the first surface 601, the visually unique color of the laminated structure 600 may be implemented by the primer.

According to various embodiments, the laminated structure 600 may include a primer positioned on the UV molding layer 721 and the first color layer 722. After disposing the primer on the UV molding layer 721, the first color layer 722 may be combined with the primer. The UV molding layer 721 and the first color layer 722 may be combined without gaps or air bubbles by the primer. In the case where the UV molding layer 721 includes the second pattern formed on the surface 742 combined with the first color layer 722, the primer may be formed in a thin film of about 1µm or less having a form conforming to the second pattern. The primer may include a material having the combination affinity with the UV molding layer 721 and the first color layer 722. According to various embodiments, the primer may have a color, and the visual color of the laminated structure 600 may be implemented by the primer when light is incident on the first surface 601.

The first color layer 722 may implement color, for example, as a translucent thin film layer. The first color layer 722 may serve to increase the surface reflectivity. For example, the first color layer 722 may be disposed on the UV molding layer 721 through various deposition methods such as physical vapor deposition (PVD). Physical vapor deposition may vaporize various metal materials such as indium, titanium oxides, aluminum oxides, or silicon oxides in a vacuum so that the vaporized metal atoms may be disposed onto the UV molding layer 721.

The second color layer 723 may implement the color, for example, as an opaque thin film layer. The color of the second color layer 723 may make the color of the first color layer 722 darker. If the rear plate 111 in FIG. 3 or the housing structure 400 in FIG. 4 including the laminated structure 600 is disposed in the electronic device 100 in FIG. 1, the second color layer 723 may serve as a visual shield such that the inside of the electronic device 100 is invisible.

According to various embodiments (not shown), the laminated structure 600 may further include various other layers or exclude some layers thereof.

According to various embodiments, the flame retardant layer 630, not limited to the embodiment in FIG. 7, may be positioned between any two layers among a plurality of layers included in the laminated structure 600.

According to various embodiments, the flame retardant layer 630 may be positioned on the first surface 601 of the polymer plate 601. In this case, the flame retardant layer 630 may be formed to be transparent or opaque, and a transparent coating layer (e.g., a UV clear layer formed of a UV curing material) may be added to protect the flame retardant layer 630 from the outside. The transparent coating layer may be, for example, a final layer to neatly protect the flame retardant layer 630 from the outside.

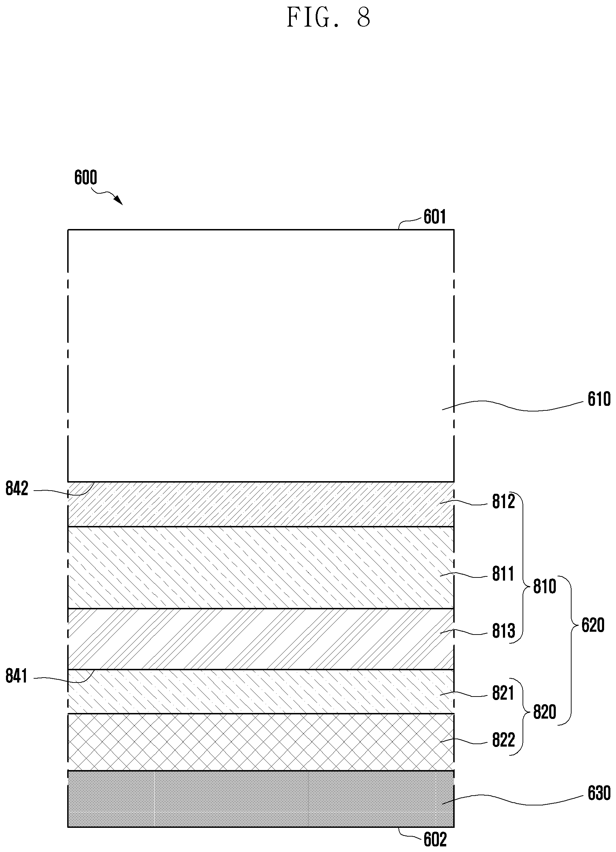

FIG. 8 illustrates a laminated structure 600 of the rear plate 111 in FIG. 3 or the housing structure 400 in FIG. 4 according to another embodiment.

Referring to FIG. 8, in an embodiment, the laminated structure 600 may include a polymer plate 610, a decoration layer 620, and a flame retardant layer 630.

According to an embodiment, the decoration layer 620 may include a first layer 810 and/or a second layer 820. The first layer 810 may be positioned between the polymer plate 610 and the second layer 820. According to an embodiment, after a composite film including the first layer 810 and the second layer 820 is manufactured, the composite film may be combined with the polymer plate 610. According to some embodiments, after the composite film including the first layer 810 is combined with the polymer plate 610, the second layer 620 may be disposed on the composite film.

According to an embodiment, the first layer 810 may include a base film 811, a transparent adhesive layer 812, and a pattern layer 813. The transparent adhesive layer 812 may be positioned between the polymer plate 610 and the base film 811. The base film 811 may be positioned between the transparent adhesive layer 812 and the pattern layer 813.

The base film 811 may be, for example, a film that is a basis for disposing at least one layer, and formed of various polymers such as polycarbonate (PC) or polyethylene terephthalate (PET). The base film (or a polymer film) 811 may include a substantially transparent or translucent material. The transparent adhesive layer 812 for combining with the polymer plate 610 may be disposed on one surface of the base film 811, and the pattern layer 813 may be disposed on the other surface of the base film 811. The visual effect of the first layer 810 may be substantially implemented by the pattern layer 813.

According to an embodiment, the pattern layer 813 may be formed through UV molding. For example, after a UV curing resin is injected into a mold including a pattern, the base film 811 is placed on the mold into which the UV curing resin has been injected and pressed, and then the UV curing resin is cured using ultraviolet rays, thereby forming the UV molding layer. Due to the thickness of the UV molding layer, the visual effect of the decoration layer 620 may be delivered to the user with the sense of depth. According to various embodiments, the UV molding layer may include a first pattern formed on a surface 841 combined with the second layer 820. The first pattern may be formed by transferring a mold pattern (e.g., an uneven pattern). The first pattern may include an uneven surface including, for example, a plurality of dimples or a plurality of slits. For example, if light passes through the first surface 601 and reaches the interface between the polymer plate 610 and the UV molding layer, the first pattern (e.g., a diffraction grating) may provide a first visual texture to the user by separating the spectrum of light according to the wavelength and enabling the user to view the monochromatic lights of the visible light. The first pattern may be implemented to provide various other visual effects. The visual effect (e.g., visual colors) implemented by the second layer 820 may be delivered to the user while the visual texture (or visual pattern) by the first pattern is added thereto. According to various embodiments (not shown), a primer may be positioned between the base film 811 and the UV molding layer. For example, the UV molding layer including the first pattern may be formed through an operation of applying a primer to the base film 811 and an operation of disposing a UV curing resin on the primer and curing the UV curing resin using ultraviolet rays. The base film 811 and the UV molding layer may be combined without gaps or air bubbles by the primer. The primer may include a material having combination affinity with the base film 811 and the UV molding layer.

According to various embodiments, the pattern layer 813 may include a gradation pattern for the visual effect of the gradation. For example, the gradation pattern may be printed on the base film 811. According to various embodiments, the pattern layer 813 may include a UV molding layer and a layer including a gradation pattern. The layer including a gradation pattern may be positioned, for example, between the base film 811 and the UV molding layer. The first pattern of the UV molding layer may be positioned on the interface between the first layer 810 and the second layer 820.

The transparent adhesive layer 812 may include, for example, an optically transparent adhesive material such as an optical clear adhesive (OCA). When the first layer 810 is combined with the polymer plate 610, a release film protecting the transparent adhesive layer 812 may be separated so that the transparent adhesive layer 812 is exposed. The transparent adhesive layer 812 may reduce the air gap between the polymer plate 610 and the base film 811. For example, if there is an air gap between the polymer plate 610 and the base film 811, distortion or loss of light may occur due to a difference in the refractive index between different media (e.g., the polymer plate 610, the air gap, and the base film 811), and accordingly, the quality of the visual effects by the polymer plate 610, the first layer 810, and/or the second layer 820 may be lowered. According to an embodiment, if the polymer plate 610 and the first layer 810 are combined without the air gap due to the transparent adhesive layer 812, the difference in the refractive index between the transparent adhesive layer 812 and the medium layer in contact therewith may be minimized so that the reflectivity of the interface between the transparent adhesive layer 812 and the medium layer in contact therewith may be lowered. Accordingly, the reflection from the interface and the distortion or loss of light according thereto may be reduced, thereby ensuring the quality of the visual effect by the polymer plate 610, the first layer 810, and/or the second layer 820.

According to an embodiment, the polymer plate 610 may include a second pattern formed on a surface 842 combined with the transparent adhesive layer 812. The second pattern may be formed by transferring the pattern included on the molding surface of the mold. The second pattern may include an uneven surface including, for example, a plurality of dimples or slits. For example, if light passes through the first surface 601 and reaches the interface between the polymer plate 610 and the transparent adhesive layer 812, the second pattern (e.g., a diffraction grating) may provide a second visual texture to the user by separating the spectrum of light according to the wavelength and enabling the user to view the monochromatic lights of the visible light. The second pattern may be implemented to provide various other visual effects. According to an embodiment, the first visual texture by the first pattern of the pattern layer 813 and the second visual texture by the second pattern of the polymer plate 610 may be delivered to the user with different sense of depths. According to various embodiments (not shown), a primer may be positioned between the polymer plate 610 and the transparent adhesive layer 812. After disposing a primer on the polymer plate 610, the first layer 810 may be combined with the primer. The polymer plate 610 and the transparent adhesive layer 812 may be combined without gaps or air bubbles by the primer. The primer may be formed in a thin film of about 1µm or less having a form conforming to the second pattern of the polymer plate 610. The primer may include a material having the combination affinity with the polymer plate 610 and the transparent adhesive layer 812. According to various embodiments, the primer may have a color, and if light is incident on the first surface 601, the visually unique color of the rear plate 111 in FIG. 3 or the housing structure 400 in FIG. 4 may be implemented by the primer.

According to an embodiment, the second layer 820 may include a first color layer 821 and/or a second color layer 822. The first color layer 821 (e.g., the first color layer 722 in FIG. 7) may implement color, for example, as a translucent thin film layer. According to various embodiments, the first color layer 821 may serve to increase the surface reflectance. For example, the first color layer 821 may be disposed on the first layer 810 through various deposition methods such as physical vapor deposition (PVD). Physical vapor deposition may vaporize various metal materials such as indium, titanium oxides, aluminum oxides, or silicon oxides in a vacuum so that the vaporized metal atoms may be coated on the surface of the first layer 810.

The second color layer 822 (e.g., the second color layer 723 in FIG. 7) may implement color, for example, as an opaque thin film layer. The color of the second color layer 822 may make the color of the first color layer 821 darker. If the rear plate 111 in FIG. 3 or the housing structure 400 in FIG. 4 including the laminated structure 600 is disposed in the electronic device 100 in FIG. 1, the second color layer 822 may serve as a shield such that the inside of the electronic device 100 is invisible.

According to various embodiments (not shown), the laminated structure 600 may further include various other layers or exclude some layers thereof.

According to various embodiments, the flame retardant layer 630, not limited to the embodiment in FIG. 8, may be positioned between any two layers among a plurality of layers included in the laminated structure 600.

According to various embodiments, the flame retardant layer 630 may be positioned on the first surface 601 of the polymer plate 601. In this case, the flame retardant layer 630 may be formed to be transparent or opaque, and a transparent coating layer (e.g., a transparent coating layer such as a UV clear layer formed of a UV curing material) may be added to protect the flame retardant layer 630 from the outside. The transparent coating layer may be, for example, a final layer to neatly protect the flame retardant layer 630 from the outside.

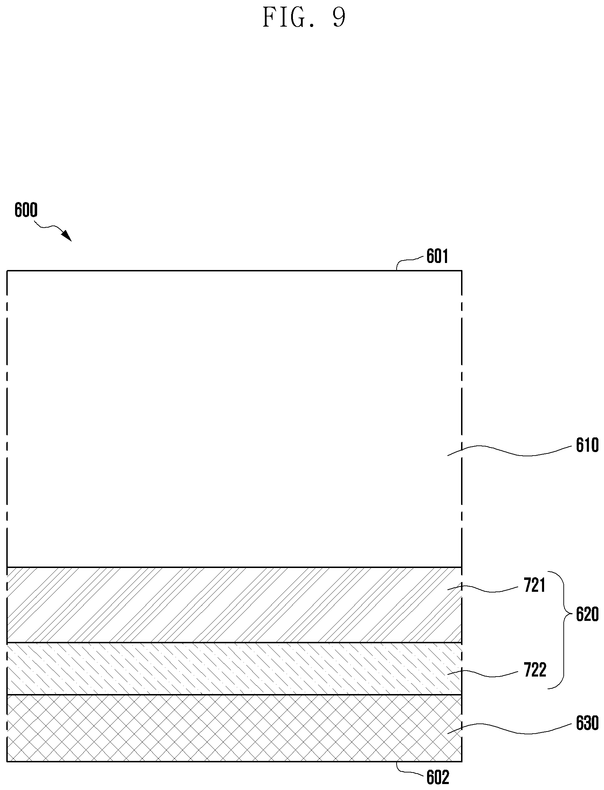

FIG. 9 illustrates a laminated structure 600 of the rear plate 111 in FIG. 3 or the housing structure 400 in FIG. 4 according to various embodiments.

Referring to FIG. 9, in an embodiment, the laminated structure 600 may include a polymer plate 610, a decoration layer 620, and a flame retardant layer 630.

According to an embodiment, the decoration layer 620 may include a UV molding layer 721 and a first color layer 722. Compared to the embodiment in FIG. 7, the decoration layer 620 may not include the second color layer 723. According to an embodiment, the flame retardant layer 630 may have a substantially opaque second color. The second color of the flame retardant layer 630 may make the first color of the first color layer 722 darker. The flame retardant layer may be formed of a two-component type paint including a flame retardant material, and the flame retardant material, a main material (e.g., polyester, acrylic, or epoxy) included in the two-component type paint, and/or a curing agent (e.g., urethane or melamine) included in the two-component type paint may have the second color. If the rear plate 111 in FIG. 3 or the housing structure 400 in FIG. 4 including the laminated structure 600 is disposed in the electronic device 100 in FIG. 1, the second color of the flame retardant layer 630 may serve as a shield such that the inside of the electronic device 100 is invisible.

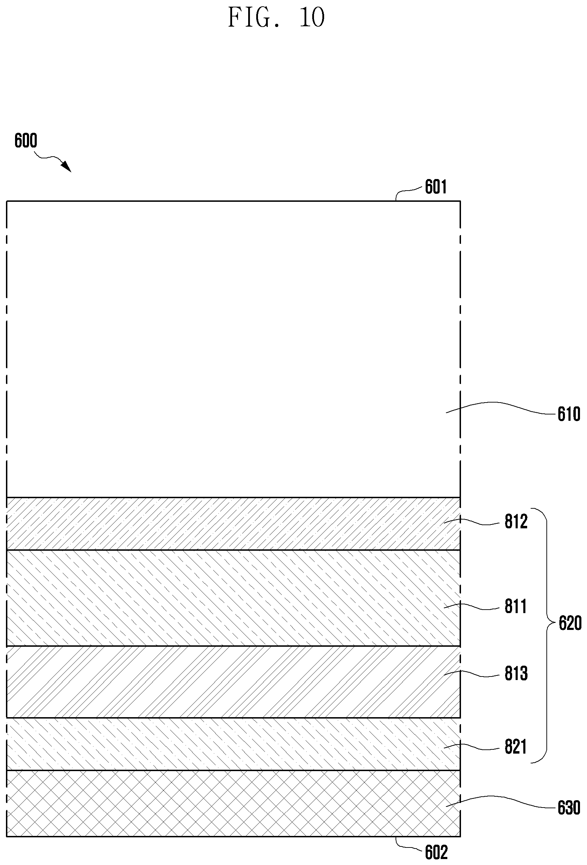

FIG. 10 illustrates a laminated structure 600 of the rear plate 111 in FIG. 3 or the housing structure 400 in FIG. 4 according to various embodiments.

Referring to FIG. 10, in an embodiment, the laminated structure 600 may include a polymer plate 610, a decoration layer 620, and a flame retardant layer 630.

According to an embodiment, the decoration layer 620 may include a transparent adhesive layer 812, a base film 811, a pattern layer 813, and/or a first color layer 821. Compared to the embodiment in FIG. 8, the decoration layer 620 may not include the second color layer 723. According to an embodiment, the flame retardant layer 630 may have a substantially opaque second color. The second color of the flame retardant layer 630 may make the first color of the first color layer 722 darker. The flame retardant layer may be formed of a two-component type paint including a flame retardant material, and the flame retardant material, a main material (e.g., polyester, acrylic, or epoxy) included in the two-component type paint, and/or a curing agent (e.g., urethane or melamine) included in the two-component type paint may have the second color. If the rear plate 111 in FIG. 3 or the housing structure 400 in FIG. 4 including the laminated structure 600 is disposed in the electronic device 100 in FIG. 1, the second color of the flame retardant layer 630 may serve as a shield such that the inside of the electronic device 100 is invisible.

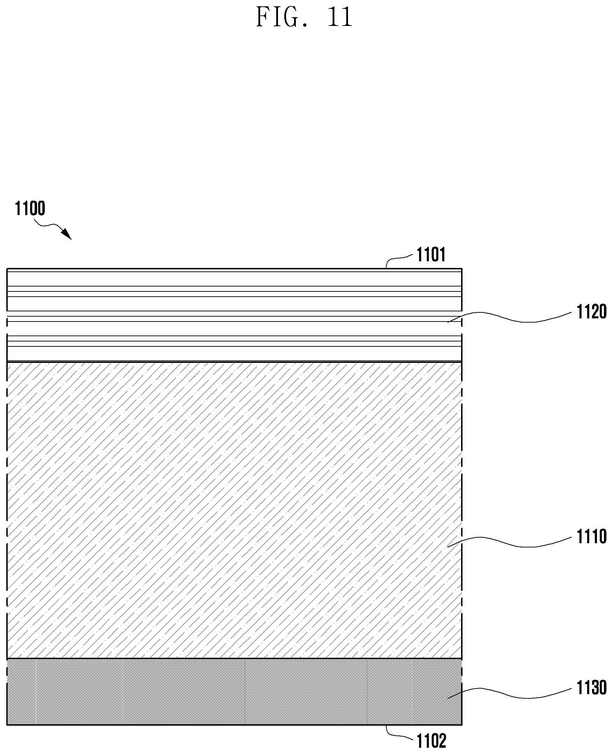

FIG. 11 illustrates a laminated structure 1100 of the rear plate 111 in FIG. 3 or the housing structure 400 in FIG. 4 according to various embodiments.

Referring to FIG. 11, the laminated structure 1100 may include, for example, a polymer plate 1110, a decoration layer 1120, and/or a flame retardant layer 1130. At least one of the elements of the laminated structure 1100 may be the same as or similar to at least one of the elements according to the embodiments in FIG. 6, 7, 8, 9, or 10, and duplicated descriptions thereof will be omitted. The polymer plate 1110 may be positioned between the decoration layer 1120 and the flame retardant layer 1130. According to an embodiment, the polymer plate 1110 may be substantially opaque. The polymer plate 1110 may include a flame retardant material or may not include a flame retardant material in some embodiments. The laminated structure 1100 may include a first surface 1101 formed by the decoration layer 1120 and a second surface 1102 formed by the flame retardant layer 1130 and facing in the opposite direction of the first surface 1101. If the rear plate 111 in FIG. 3 or the housing structure 400 in FIG. 4 including the laminated structure 1100 is disposed in the electronic device 100 in FIG. 1, the first surface 1101 may form the outer surface of the electronic device 100, and the second surface 1102 may form the inner surface of the electronic device 100.

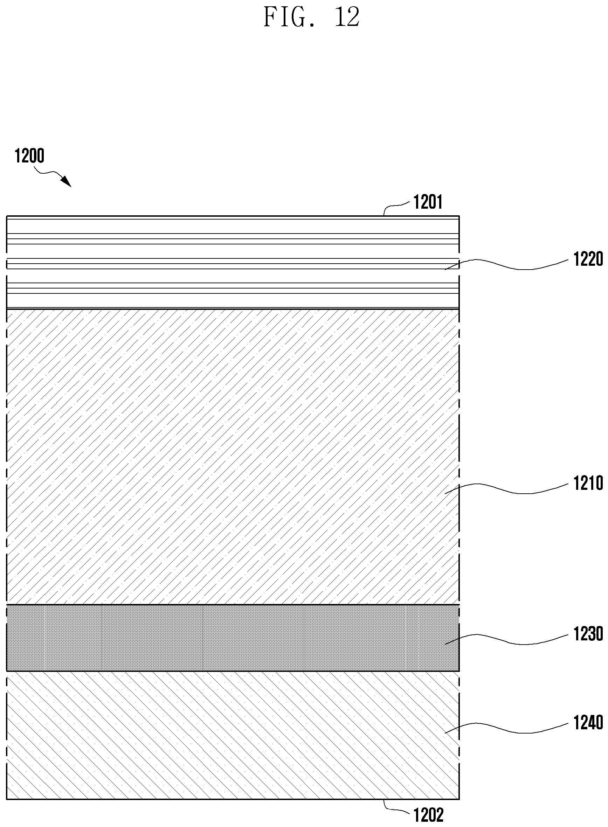

FIG. 12 illustrates a laminated structure 1200 of the rear plate 111 in FIG. 3 or the housing structure 400 in FIG. 4 according to various embodiments.

Referring to FIG. 12, the laminated structure 1200 may include, for example, a polymer plate 1210, a decoration layer 1220, a flame retardant layer 1230, and/or a metal sheet 1240. The polymer plate 1210 may be positioned between the decoration layer 1220 and the flame retardant layer 1230. The flame retardant layer 1230 may be positioned between the polymer plate 1210 and the metal sheet 1240. According to an embodiment, the polymer plate 1210 may be substantially opaque. The polymer plate 1210 may include a flame retardant material or may not include a flame retardant material in some embodiments. The laminated structure 1200 may include a first surface 1201 formed by the decoration layer 1220 and a second surface 1202 formed by the metal sheet 1240 and facing in the opposite direction of the first surface 1201. If the rear plate 111 in FIG. 3 or the housing structure 400 in FIG. 4 including the laminated structure 1200 is disposed in the electronic device 100 in FIG. 1, the first surface 1201 may form the outer surface of the electronic device 100, and the second surface 1202 may form the inner surface of the electronic device 100.

According to an embodiment, the metal sheet 1240 may contribute to the durability or impact resistance capable of reducing damage to the laminated structure 1200 or the flame retardant layer 1230 against the external impact or external pressure. The metal sheet 1240 may include various metal materials such as stainless steel or aluminum. The metal sheet 1240 may reduce, for example, the stress effect of the battery 350 in FIG. 3 or FIG. 4 on the flame retardant layer 1230. Various adhesive materials of polymer may be positioned between the metal sheet 1240 and the flame retardant layer 1230.

According to various embodiments, the metal sheet 1240 may be implemented as a support structure that is separated from the flame retardant layer 1230.

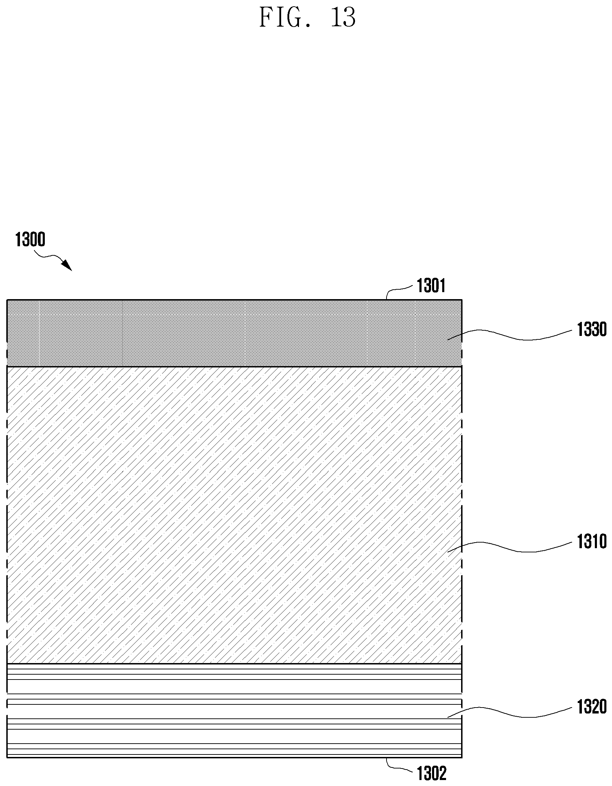

FIG. 13 illustrates a laminated structure 1300 of the rear plate 111 in FIG. 3 or the housing structure 400 in FIG. 4 according to various embodiments.

Referring to FIG. 13, for example, the laminated structure 1300 may include a polymer plate 1310, a decoration layer 1320, and/or a flame retardant layer 1330. At least one of the elements of the laminated structure 110 may be the same or similar to at least one of the elements according to the embodiments in FIG. 6, 7, 8, 9, or 10, and duplicated descriptions thereof will be omitted. The polymer plate 1310 may be positioned between the decoration layer 1320 and the flame retardant layer 1330. According to an embodiment, the polymer plate 1310 may be substantially transparent. The polymer plate 1310 may include a flame retardant material or may not include a flame retardant material in some embodiments. The laminated structure 1300 may include a first surface 1301 formed by the flame retardant layer 1330 and a second surface 1302 formed by the decoration layer 1320 and facing in the opposite direction of the first surface 1301. If the rear plate 111 in FIG. 3 or the housing structure 400 in FIG. 4 including the laminated structure 1300 is disposed in the electronic device 100 in FIG. 1, the first surface 1301 may form the outer surface of the electronic device 100 and the second surface 1302 may form the inner surface of the electronic device 100.

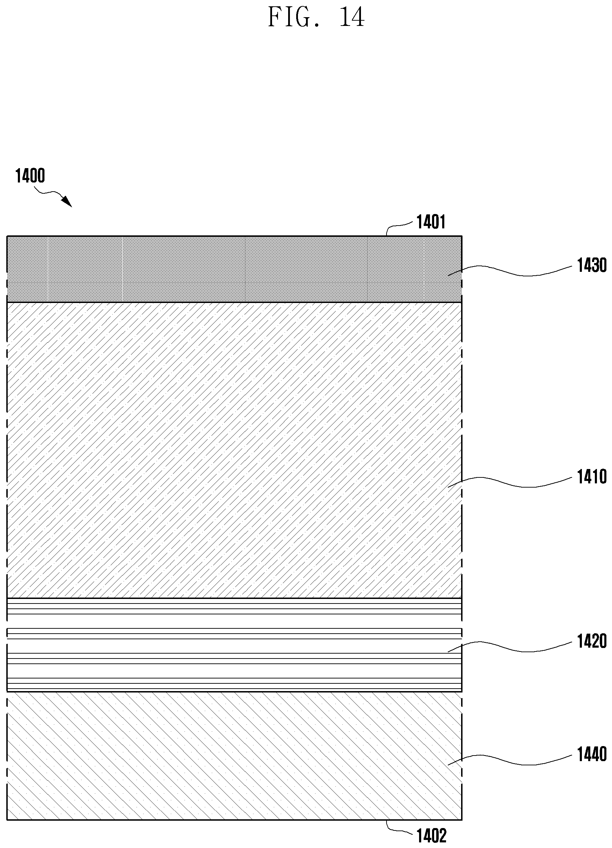

FIG. 14 illustrates a laminated structure 1400 of the rear plate 111 in FIG. 3 or the housing structure 400 in FIG. 4 according to various embodiments.

Referring to FIG. 14, for example, the laminated structure 1400 may include a polymer plate 1410, a decoration layer 1420, a flame retardant layer 1430, and/or a metal sheet 1440. The polymer plate 1410 may be positioned between the decoration layer 1420 and the flame retardant layer 1430. The decoration layer 1420 may be positioned between the polymer plate 1410 and the metal sheet 1440. According to an embodiment, the polymer plate 1410 may be substantially transparent. The polymer plate 1410 may include a flame retardant material or may not include a flame retardant material in some embodiments. The laminated structure 1400 may include a first surface 1401 formed by the flame retardant layer 1420 and a second surface 1402 formed by the metal sheet 1440 and facing in the opposite direction of the first surface 1401. If the rear plate 111 in FIG. 3 or the housing structure 400 in FIG. 4 including the laminated structure 1400 is disposed in the electronic device 100 in FIG. 1, the first surface 1401 may form the outer surface of the electronic device 100 and the second surface 1402 may form the inner surface of the electronic device 100.

According to an embodiment, the metal sheet 1440 may contribute to the durability or impact resistance capable of reducing damage to the laminated structure 1400 or the flame retardant layer 1230 against the external shock or external pressure. The metal sheet 1240 may include various metal materials such as stainless steel or aluminum. The metal sheet 1440 may reduce, for example, the stress effect of the battery 350 in FIG. 3 or 4 on the flame retardant layer 1430. Various adhesive materials of polymer may be positioned between the metal sheet 1240 and the flame retardant layer 1230.

According to various embodiments, the metal sheet 1440 may be implemented as a support structure that is separated from the decoration layer 1420.

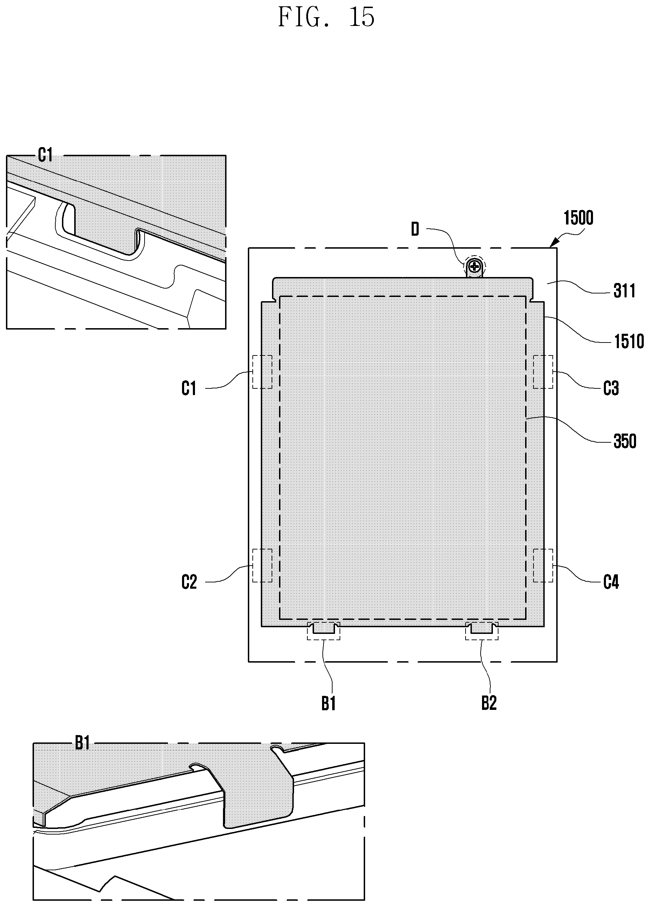

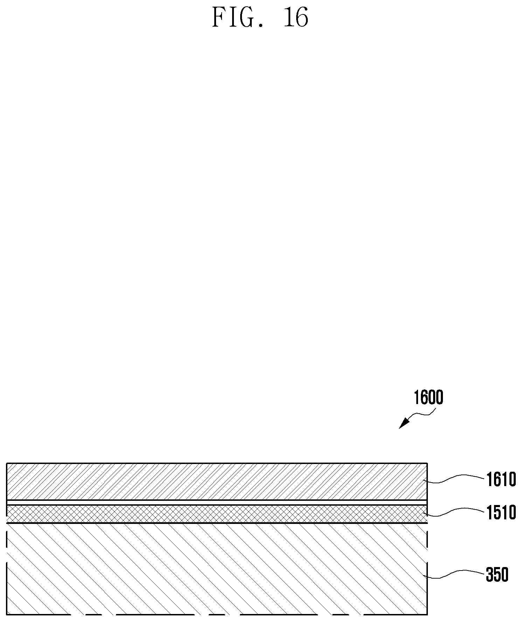

FIG. 15 illustrates an assembly 1500 including a first support member 311, a battery 350, and a metal support member 1510 according to an embodiment. FIG. 16 illustrates a laminated structure 1600 of a cover member 1610, a metal support member 1510, and a battery 350 according to an embodiment.

Referring to FIGS. 15 and 16, the metal support member 1510 may be coupled to a first support member 311 between the cover member 1610 (e.g., the rear plate 111 in FIG. 3 or the housing structure 400 in FIG. 4) and the first support member 311. For example, as shown in a portion denoted by a reference numeral "B1" (or a portion denoted by a reference numeral "B2") or a portion denoted by a reference numeral "C1" (or portions denoted by reference numerals "C2", "C3", and "C4"), the edge of the metal support member 1510 may be fastened to the first support member 311 using snap-fitting. As shown in a portion denoted by a reference numeral "D", a part of the other edges of the metal member 1510 may be fastened to the first support member 311 using bolt fastening. In various embodiments, the metal support member 1510 may be coupled to the first support member 311 and a printed circuit board (e.g., the printed circuit board 340 in FIG. 3) using bolt fastening. The battery 350 may be positioned between the metal support member 1510 and the first support member 311. When the external impact or external pressure is applied to the electronic device 100 in FIG. 1, the metal support member 1510 and/or the first support member 311 may reduce or prevent shaking, flow, or vibration of the battery 350. The metal support member 1510, in an embodiment, may reduce the stress effect of the battery 350 on a flame retardant layer (e.g., the flame retardant layer 630 in FIG. 6, 7, 8, 9, or 10, the flame retardant layer 1130 in FIG. 11, the flame retardant layer 1220 in FIG. 12, the flame retardant layer 1320 in FIG. 13, or the flame retardant layer 1420 in FIG. 14) of the cover member 1610 (e.g., the rear plate 111 in FIG. 3 or the housing structure 400 in FIG. 4).

According to various embodiments, the electronic device 100 in FIG. 1 may include at least one antenna radiator at least partially overlapping the rear plate 111 in FIG. 3 or the flat portion 410 in FIG. 4 when viewed toward the rear surface 110B. According to an embodiment, in the rear plate 111 in FIG. 3 or the housing structure 400 in FIG. 4, the flame retardant layer (e.g., the flame retardant layer 630 in FIG. 6, 7, 8, 9, or 10, the flame retardant layer 1130 in FIG. 11, the flame retardant layer 1220 in FIG. 12, the flame retardant layer 1320 in FIG. 13, or the flame retardant layer 1420 in FIG. 14) may be disposed to not overlap at least one antenna radiator (e.g., the antenna 370 in FIG. 3 or 4). A flame retardant material (e.g., an inorganic flame retardant material) included in the flame retardant layer may have electrical conductivity. In the case where the flame retardant layer does not overlap at least one antenna radiator, the effect of the flame retardant layer on the antenna radiation performance may be reduced.

According to an embodiment of the disclosure, an electronic device (e.g., the electronic device 100 in FIG. 1) may include a housing (e.g., the housing 110 in FIG. 1) configured to form at least one surface of the electronic device. The electronic device may include a flame retardant layer (e.g., the flame retardant layer 630 in FIG. 6, 7, 8, 9 or 10, the flame retardant layer 1130 in FIG. 11, the flame retardant layer 1230 in FIG. 12, the flame retardant layer 1330 in FIG. 13, or the flame retardant layer 1430 in FIG. 14) disposed in the housing. The flame retardant layer may include a two-component type paint and a flame retardant material.

According to an embodiment of the disclosure, the flame retardant material may include an inorganic material including magnesium hydroxide, aluminum hydroxide, tin zinc, phosphorus-based materials, guanidine-based materials, molybdate, or zirconium.

According to an embodiment of the disclosure, a main material included in the two-component type paint may include a polymer softer than the flame retardant material. The main material may include polyester, acrylic, or epoxy.

According to an embodiment of the disclosure, a curing agent included in the two-component type paint may include urethane or melamine.

According to an embodiment of the disclosure, the flame retardant material may have a weight ratio of 10% to 30% with respect to the two-component type paint.

According to an embodiment of the disclosure, the housing (e.g., the rear plate 111 in FIG. 3 or the housing structure 400 in FIG. 4) may include a polymer plate (e.g., the polymer plate 610 in FIG. 6) and a decoration layer (e.g., the decoration layer 620 in FIG. 6) disposed on the polymer plate. The decoration layer may include at least one of a color layer (e.g., the first color layer 722 or the second color layer 723 in FIG. 7, the first color layer 821 or the second color layer 822 in FIG. 8, the first color layer 722 in FIG. 9, or the first color layer 821 in FIG. 10) and a UV molding layer (e.g., the UV molding layer 721 in FIG. 7 or 9, or the pattern layer 813 in FIG. 8 or 10).

According to an embodiment of the disclosure, the polymer plate (e.g., the polymer plate 610 in FIG. 6) may be transparent. The decoration layer (e.g., the decoration layer 620 in FIG. 6) may be positioned between the polymer plate and the flame retardant layer (e.g., the flame retardant layer 630 in FIG. 6).

According to an embodiment of the disclosure, the polymer plate (e.g., the polymer plate 1110 in FIG. 11, the polymer plate 1210 in FIG. 12, the polymer plate 1310 in FIG. 13, or the polymer plate 1410 in FIG. 14) may be opaque. The polymer plate may be positioned between the decoration layer (e.g., the decoration layer 1120 in FIG. 11, the decoration layer 1220 in FIG. 12, the decoration layer 1320 in FIG. 13, or the decoration layer 1420 in FIG. 14) and the flame retardant layer (e.g., the flame retardant layer 1130 in FIG. 11, the flame retardant layer 1230 in FIG. 12, the flame retardant layer 1330 in FIG. 13, or the flame retardant layer 1430 in FIG. 14).

According to an embodiment of the disclosure, the flame retardant layer (e.g., the flame retardant layer 630 in FIG. 9 or the flame retardant layer 630 in FIG. 10) may be opaque.

According to an embodiment of the disclosure, the housing (e.g., the housing structure 400 in FIG. 4) may include a flat portion (e.g., the flat portion 410 in FIG. 4) and at least one curved portion (e.g., the curved portion 420 in FIG. 4) extending from the flat portion.

According to an embodiment of the disclosure, the housing (e.g., the housing 110 in FIG. 1) may include a first plate (e.g., the front plate 102 in FIG. 1) configured to form a front surface of the electronic device. The housing may include a second plate (e.g., the rear plate 111 in FIG. 3) forming a rear surface of the electronic device or a second plate (e.g., the housing structure 400 in FIG. 4) extending integrally from a side surface at least surrounding a space between the front surface and the rear surface to the rear surface. The electronic device may include a display (e.g., the display 101 in FIG. 3 or 4) positioned in an inner space of the housing and at least partially viewed through the first plate. The flame retardant layer (e.g., the flame retardant layer 630 in FIG. 6, 7, 8, 9 or 10, the flame retardant layer 1130 in FIG. 11, the flame retardant layer 1230 in FIG. 12, the flame retardant layer 1330 in FIG. 13, or the flame retardant layer 1430 in FIG. 14) may be disposed on the second plate.

According to an embodiment of the disclosure, the electronic device may further include a metal support member (e.g., the metal support member 1510 in FIG. 15 or 16) at least partially positioned between the flame retardant layer (e.g., the flame retardant layer in FIG. 16 (e.g., the flame retardant layer 630 in FIG. 6, 7, 8, 9 or 10, the flame retardant layer 1130 in FIG. 11, the flame retardant layer 1230 in FIG. 12, the flame retardant layer 1330 in FIG. 13, or the flame retardant layer 1430 in FIG. 14)) and a battery (e.g., the battery 350 in FIG. 16) positioned in an inner space of the housing.

According to an embodiment of the disclosure, the flame retardant layer (e.g., the flame retardant layer 630 in FIG. 6, 7, 8, 9 or 10, the flame retardant layer 1130 in FIG. 11, the flame retardant layer 1230 in FIG. 12, the flame retardant layer 1330 in FIG. 13, or the flame retardant layer 1430 in FIG. 14) may not overlap at least one antenna (e.g., the antenna 370 in FIG. 3 or 4) positioned in an inner space of the housing.

According to an embodiment of the disclosure, the electronic device (e.g., the electronic device 100 in FIG. 1) may include a housing (e.g., the housing structure 400 in FIG. 4) including a flat portion (e.g., the flat portion 410 in FIG. 4) and at least one curved portion (e.g., the curved portion 420 in FIG. 4) extending from the flat portion. The electronic device may include a flame retardant layer (e.g., the flame retardant layer 630 in FIG. 6, 7, 8, 9 or 10, the flame retardant layer 1130 in FIG. 11, the flame retardant layer 1230 in FIG. 12, the flame retardant layer 1330 in FIG. 13, or the flame retardant layer 1430 in FIG. 14) disposed in the housing. The flame retardant layer may include a two-component type paint and a flame retardant material.

According to an embodiment of the disclosure, the flame retardant material may include an inorganic flame retardant material including magnesium hydroxide, aluminum hydroxide, tin zinc, phosphorus-based materials, guanidine-based materials, molybdate, or zirconium. A main material included in the two-component type paint may be a polymer softer than the flame retardant material and may include polyester, acrylic, or epoxy. A curing agent included in the two-component type paint may include urethane or melamine.

According to an embodiment of the disclosure, the housing may include a transparent polymer plate (e.g., the polymer plate 610 in FIG. 6) and a decoration layer (e.g., the decoration layer 620 in FIG. 6) disposed on the polymer plate. The decoration layer may be positioned between the polymer plate and the flame retardant layer (e.g., the flame retardant layer 630 in FIG. 6). The decoration layer may include at least one of a color layer (e.g., the first color layer 722 or the second color layer 723 in FIG. 7, the first color layer 821 or the second color layer 822 in FIG. 8, the first color layer 722 in FIG. 9, or the first color layer 821 in FIG. 10) and a UV molding layer (e.g., the UV molding layer 721 in FIG. 7 or 9, or the pattern layer 813 in FIG. 8 or 10).

According to an embodiment of the disclosure, a method for manufacturing a housing included in an electronic device may include forming a transparent polymer plate (e.g., the operation 510 in FIG. 5), forming a decoration layer disposed on the polymer plate (e.g., the operation 520 in FIG. 5), and forming a flame retardant layer on the decoration layer (e.g., the operation 530 in FIG. 5). The flame retardant layer (e.g., the flame retardant layer 630 in FIG. 6, 7, 8, 9 or 10, the flame retardant layer 1130 in FIG. 11, the flame retardant layer 1230 in FIG. 12, the flame retardant layer 1330 in FIG. 13, or the flame retardant layer 1430 in FIG. 14) may include a two-component type paint and a flame retardant material.

According to an embodiment of the disclosure, the flame retardant layer may be disposed on the decoration layer by spraying or printing.

According to an embodiment of the disclosure, the flame retardant material may include an inorganic flame retardant material including magnesium hydroxide, aluminum hydroxide, tin zinc, phosphorus-based materials, guanidine-based materials, molybdate, or zirconium. A main material included in the two-component type paint may be a polymer softer than the flame retardant material, and the main material included in the two-component type paint may include polyester, acrylic, or epoxy. A curing agent included in the two-component type paint may include urethane or melamine.

According to an embodiment of the disclosure, the flame retardant material may have a weight ratio of 10% to 30% with respect to the two-component type paint.

The embodiments of the disclosure described and shown in the specification and the drawings are merely specific examples that have been presented to easily explain the technical contents of the disclosure and help understanding of the disclosure, and are not intended to limit the scope of embodiments of the disclosure. Therefore, the scope of various embodiments of the disclosure should be construed to include, in addition to the embodiments disclosed herein, all changes and modifications falling within the scope of various embodiments of the disclosure.

## Claims

1. An electronic device (100) comprising:
a housing (110, 400) configured to form at least one surface of the electronic device (100); and
a flame retardant layer (630, 1130, 1330, 1230, 1430) disposed in the housing (110, 400),
wherein the flame retardant layer (630, 1130, 1330, 1230, 1430) comprises a two-component type paint and a flame retardant material, and is formed by mixing of the flame retardant material with a main material of the two-component type paint before curing the mixture with a curing agent of the two-component type paint.

2. The electronic device (100) of claim 1, wherein the flame retardant material comprises an inorganic material comprising magnesium hydroxide, aluminum hydroxide, tin zinc, phosphorus-based materials, guanidine-based materials, molybdate, or zirconium.

3. The electronic device (100) of claim 1 or 2, wherein a main material included in the two-component type paint comprises a polymer softer than the flame retardant material, and
wherein the main material comprises polyester, acrylic, or epoxy.

4. The electronic device (100) of any one of the preceding claims, wherein a curing agent included in the two-component type paint comprises urethane or melamine.

5. The electronic device (100) of any one of the preceding claims, wherein the flame retardant material has a weight ratio of 10% to 30% with respect to the two-component type paint.

6. The electronic device (100) of any one of the preceding claims, wherein the housing (110, 400) comprises a polymer plate (610) and a decoration layer (620, 1120, 1220, 1320, 1420) disposed on the polymer plate (610), and
wherein the decoration layer (620) comprises at least one of a color layer (722, 723, 821, 822) and a UV molding layer (721, 813).

7. The electronic device (100) of claim 6, wherein the polymer plate (610) is transparent, and
wherein the decoration layer (620, 1120, 1220, 1320, 1420) is positioned between the polymer plate (610) and the flame retardant layer (630, 1130, 1330, 1230, 1430).

8. The electronic device (100) of claim 6, wherein the polymer plate (610) is opaque, and
wherein the polymer plate (610) is positioned between the decoration layer (620, 1120, 1220, 1320, 1420) and the flame retardant layer (630, 1130, 1330, 1230, 1430).

9. The electronic device (100) of any one of the preceding claims, wherein the flame retardant layer (630, 1130, 1330, 1230, 1430) is opaque.

10. The electronic device (100) of any one of the preceding claims, wherein the housing (110, 400) comprises a flat portion (410) and at least one curved portion (420) extending from the flat portion (410).

11. The electronic device (100) of any one of the preceding claims, wherein the housing (110, 400) comprises:
a first plate (102) configured to form a front surface of the electronic device (100); and
a second plate (111, 400) configured to form a rear surface of the electronic device (100) or extend integrally from a side surface at least surrounding a space between the front surface and the rear surface to the rear surface,
wherein the electronic device (100) further comprises a display (101) positioned in an inner space of the housing (110, 400) and at least partially viewed through the first plate (102), and
wherein the flame retardant layer (630, 1130, 1330, 1230, 1430) is disposed on the second plate (111, 400).

12. The electronic device (100) of claim 11, further comprising a metal support member (1510) at least partially positioned between the flame retardant layer (630, 1130, 1330, 1230, 1430) and a battery (350) positioned in an inner space of the housing (110, 400).

13. The electronic device (100) of any one of the preceding claims, wherein the flame retardant layer (630, 1130, 1330, 1230, 1430) does not overlap at least one antenna (370) positioned in an inner space of the housing (110, 400).

14. A method of manufacturing a housing (110, 400) forming at least one surface of an electronic device (100), the method comprising:
forming a flame retardant layer (630, 1130, 1330, 1230, 1430) as part of the housing (110, 400),
wherein the flame retardant layer (630, 1130, 1330, 1230, 1430) comprises a two-component type paint and a flame retardant material, and is formed by mixing of the flame retardant material with a main material of the two-component type paint before curing the mixture with a curing agent of the two-component type paint.

15. The method of claim 14, wherein the flame retardant material comprises an inorganic material comprising magnesium hydroxide, aluminum hydroxide, tin zinc, phosphorus-based materials, guanidine-based materials, molybdate, or zirconium,
wherein a main material included in the two-component type paint is a polymer softer than the flame retardant material,
wherein the main material included in the two-component type paint comprises polyester, acrylic, or epoxy, and
wherein a curing agent included in the two-component type paint comprises urethane or melamine.

## Patentansprüche

1. Elektronische Vorrichtung (100), umfassend:
ein Gehäuse (110, 400), das konfiguriert ist, um mindestens eine Fläche der elektronischen Vorrichtung (100) zu bilden; und
eine Flammschutzschicht (630, 1130, 1330, 1230, 1430), die im Gehäuse (110, 400) angeordnet ist,
wobei die Flammschutzschicht (630, 1130, 1330, 1230, 1430) eine Zweikomponentenfarbe und ein Flammschutzmaterial umfasst und durch Mischen des Flammschutzmaterials mit einem Hauptmaterial der Zweikomponentenfarbe vor einem Aushärten des Gemischs mit einem Vernetzer der Zweikomponentenfarbe ausgebildet wird.

2. Elektronische Vorrichtung (100) nach Anspruch 1, wobei das Flammschutzmaterial ein anorganisches Material umfasst, das Magnesiumhydroxid, Aluminiumhydroxid, Zinn-Zink, phosphorbasierte Materialien, guanidinbasierte Materialien, Molybdat oder Zirkonium umfasst.

3. Elektronische Vorrichtung (100) nach Anspruch 1 oder 2, wobei ein Hauptmaterial, das in der Zweikomponentenfarbe enthalten ist, ein Polymer umfasst, das weicher als das Flammschutzmaterial ist, und
wobei das Hauptmaterial Polyester, Acryl oder Epoxid umfasst.

4. Elektronische Vorrichtung (100) nach einem der vorhergehenden Ansprüche, wobei ein in der Zweikomponentenfarbe enthaltener Vernetzer Urethan oder Melamin umfasst.

5. Elektronische Vorrichtung (100) nach einem der vorhergehenden Ansprüche, wobei das Flammschutzmaterial ein Gewichtsverhältnis von 10 % bis 30 % in Bezug auf die Zweikomponentenfarbe aufweist.

6. Elektronische Vorrichtung (100) nach einem der vorhergehenden Ansprüche, wobei das Gehäuse (110, 400) eine Polymerplatte (610) und eine Dekorationsschicht (620, 1120, 1220, 1320, 1420) umfasst, die auf der Polymerplatte (610) angeordnet ist, und
wobei die Dekorationsschicht (620) mindestens eine von einer Farbschicht (722, 723, 821, 822) und einer UV-Formschicht (721, 813) umfasst.

7. Elektronische Vorrichtung (100) nach Anspruch 6, wobei die Polymerplatte (610) transparent ist, und
wobei die Dekorationsschicht (620, 1120, 1220, 1320, 1420) zwischen der Polymerplatte (610) und der Flammschutzschicht (630, 1130, 1330, 1230, 1430) positioniert ist.

8. Elektronische Vorrichtung (100) nach Anspruch 6, wobei die Polymerplatte (610) undurchsichtig ist, und
wobei die Polymerplatte (610) zwischen der Dekorationsschicht (620, 1120, 1220, 1320, 1420) und der Flammschutzschicht (630, 1130, 1330, 1230, 1430) positioniert ist.

9. Elektronische Vorrichtung (100) nach einem der vorhergehenden Ansprüche, wobei die Flammschutzschicht (630, 1130, 1330, 1230, 1430) undurchsichtig ist.

10. Elektronische Vorrichtung (100) nach einem der vorhergehenden Ansprüche, wobei das Gehäuse (110, 400) einen flachen Abschnitt (410) und mindestens einen gekrümmten Abschnitt (420) umfasst, der sich von dem flachen Abschnitt (410) erstreckt.

11. Elektronische Vorrichtung (100) nach einem der vorhergehenden Ansprüche, wobei das Gehäuse (110, 400) Folgendes umfasst:
eine erste Platte (102), die konfiguriert ist, um eine vordere Fläche der elektronischen Vorrichtung (100) zu bilden; und
eine zweite Platte (111, 400), die konfiguriert ist, um eine hintere Fläche der elektronischen Vorrichtung (100) zu bilden oder sich einstückig von einer Seitenfläche, die mindestens einen Raum zwischen der vorderen Fläche und der hinteren Fläche umgibt, zur hinteren Fläche zu erstrecken,
wobei die elektronische Vorrichtung (100) ferner eine Anzeige (101) umfasst, die in einem Innenraum des Gehäuses (110, 400) positioniert ist und mindestens teilweise durch die erste Platte (102) betrachtet wird, und
wobei die Flammschutzschicht (630, 1130, 1330, 1230, 1430) auf der zweiten Platte (111, 400) angeordnet ist.

12. Elektronische Vorrichtung (100) nach Anspruch 11, ferner umfassend ein Metallträgerelement (1510), das mindestens teilweise zwischen der Flammschutzschicht (630, 1130, 1330, 1230, 1430) und einer Batterie (350) angeordnet ist, die in einem Innenraum des Gehäuses (110, 400) positioniert ist.

13. Elektronische Vorrichtung (100) nach einem der vorhergehenden Ansprüche, wobei die Flammschutzschicht (630, 1130, 1330, 1230, 1430) mindestens eine Antenne (370), die in einem Innenraum des Gehäuses (110, 400) positioniert ist, nicht überlappt.

14. Verfahren zum Herstellen eines Gehäuses (110, 400), das mindestens eine Fläche einer elektronischen Vorrichtung (100) bildet, wobei das Verfahren Folgendes umfasst:
Bilden einer Flammschutzschicht (630, 1130, 1330, 1230, 1430) als Teil des Gehäuses (110, 400),
wobei die Flammschutzschicht (630, 1130, 1330, 1230, 1430) eine Zweikomponentenfarbe und ein Flammschutzmaterial umfasst und durch Mischen des Flammschutzmaterials mit einem Hauptmaterial der Zweikomponentenfarbe vor einem Aushärten des Gemischs mit einem Vernetzer der Zweikomponentenfarbe ausgebildet wird.

15. Verfahren nach Anspruch 14, wobei das Flammschutzmaterial ein anorganisches Material umfasst, das Magnesiumhydroxid, Aluminiumhydroxid, Zinn-Zink, phosphorbasierte Materialien, guanidinbasierte Materialien, Molybdat oder Zirkonium umfasst,
wobei ein Hauptmaterial, das in der Zweikomponentenfarbe enthalten ist, ein Polymer umfasst, das weicher als das Flammschutzmaterial ist,
wobei das Hauptmaterial, das in der Zweikomponentenfarbe enthalten ist, Polyester, Acryl oder Epoxid umfasst, und
wobei ein in der Zweikomponentenfarbe enthaltener Vernetzer Urethan oder Melamin umfasst.

## Revendications

1. Dispositif électronique (100), comprenant :
un boîtier (110, 400) configuré pour former au moins une surface du dispositif électronique (100) ; et
une couche ignifuge (630, 1130, 1330, 1230, 1430) disposée dans le boîtier (110, 400),
dans lequel la couche ignifuge (630, 1130, 1330, 1230, 1430) comprend une peinture de type à deux composants et un matériau ignifuge, et est formée par mélange du matériau ignifuge avec un matériau principal de la peinture de type à deux composants avant de durcir le mélange avec un agent de durcissement de la peinture de type à deux composants.

2. Dispositif électronique (100) de la revendication 1, dans lequel le matériau ignifuge comprend un matériau inorganique comprenant de l'hydroxyde de magnésium, de l'hydroxyde d'aluminium, de l'étain-zinc, des matériaux à base de phosphore, des matériaux à base de guanidine, du molybdate ou du zirconium.

3. Dispositif électronique (100) de la revendication 1 ou 2, dans lequel un matériau principal inclus dans la peinture de type à deux composants comprend un polymère plus souple que le matériau ignifuge, et
dans lequel le matériau principal comprend du polyester, de l'acrylique ou de l'époxy.

4. Dispositif électronique (100) de l'une quelconque des revendications précédentes, dans lequel un agent de durcissement compris dans la peinture de type à deux composants comporte de l'uréthane ou de la mélamine.

5. Dispositif électronique (100) de l'une quelconque des revendications précédentes, dans lequel le matériau ignifuge présente un rapport en poids de 10 % à 30 % par rapport à la peinture de type a deux composants.

6. Dispositif électronique (100) de l'une quelconque des revendications précédentes, dans lequel le boîtier (110, 400) comprend une plaque de polymère (610) et une couche de décoration (620, 1120, 1220, 1320, 1420) disposée sur la plaque de polymère (610), et
dans lequel la couche de décoration (620) comprend au moins une parmi une couche de couleur (722, 723, 821, 822) et une couche de moulage UV (721, 813).

7. Dispositif électronique (100) de la revendication 6, dans lequel la plaque de polymère (610) est transparente, et
dans lequel la couche de décoration (620, 1120, 1220, 1320, 1420) est positionnée entre la plaque de polymère (610) et la couche ignifuge (630, 1130, 1330, 1230, 1430).

8. Dispositif électronique (100) de la revendication 6, dans lequel la plaque de polymère (610) est opaque, et
dans lequel la plaque de polymère (610) est positionnée entre la couche de décoration (620, 1120, 1220, 1320, 1420) et la couche ignifuge (630, 1130, 1330, 1230, 1430).

9. Dispositif électronique (100) de l'une quelconque des revendications précédentes, dans lequel la couche ignifuge (630, 1130, 1330, 1230, 1430) est opaque.

10. Dispositif électronique (100) de l'une quelconque des revendications précédentes, dans lequel le boîtier (110, 400) comprend une partie plate (410) et au moins une partie incurvée (420) s'étendant à partir de la partie plate (410).

11. Dispositif électronique (100) de l'une quelconque des revendications précédentes, dans lequel le boîtier (110, 400) comprend :
une première plaque (102) configurée pour former une surface avant du dispositif électronique (100) ; et
une deuxième plaque (111, 400) configurée pour former une surface arrière du dispositif électronique (100) ou s'étendre intégralement depuis une surface latérale au moins entourant un espace entre la surface avant et la surface arrière jusqu'à la surface arrière,
dans lequel le dispositif électronique (100) comprend en outre un affichage (101) positionné dans un espace intérieur du boîtier (110, 400) et au moins partiellement vu à travers la première plaque (102), et
dans lequel la couche ignifuge (630, 1130, 1330, 1230, 1430) est disposée sur la deuxième plaque (111, 400).

12. Dispositif électronique (100) de la revendication 11, comprenant en outre un élément de support métallique (1510) au moins partiellement positionné entre la couche ignifuge (630, 1130, 1330, 1230, 1430) et une batterie (350) positionnée dans un espace intérieur du boîtier (110, 400).

13. Dispositif électronique (100) de l'une quelconque des revendications précédentes, dans lequel la couche ignifuge (630, 1130, 1330, 1230, 1430) ne chevauche pas au moins une antenne (370) positionnée dans un espace intérieur du boîtier (110, 400).

14. Procédé de fabrication d'un boîtier (110, 400) formant au moins une surface d'un dispositif électronique (100), le procédé comprenant :
former une couche ignifuge (630, 1130, 1330, 1230, 1430) en tant que partie du boîtier (110, 400),
dans lequel la couche ignifuge (630, 1130, 1330, 1230, 1430) comprend une peinture de type à deux composants et un matériau ignifuge, et est formée par mélange du matériau ignifuge avec un matériau principal de la peinture de type à deux composants avant de durcir le mélange avec un agent de durcissement de la peinture de type à deux composants.

15. Procédé de la revendication 14, dans lequel le matériau ignifuge comprend un matériau inorganique comprenant de l'hydroxyde de magnésium, de l'hydroxyde d'aluminium, de l'étain-zinc, des matériaux à base de phosphore, des matériaux à base de guanidine, du molybdate ou du zirconium,
dans lequel un matériau principal inclus dans la peinture de type à deux composants est un polymère plus souple que le matériau ignifuge,
dans lequel le matériau principal compris dans la peinture de type à deux composants comprend du polyester, de l'acrylique ou de l'époxy, et
dans lequel un agent de durcissement compris dans la peinture de type à deux composants comprend de l'uréthane ou de la mélamine.
